# EUROPEAN PATENT SPECIFICATION

(11) **EP 3 497 458 B1**
(45) Date of publication and mention of the grant of the patent: **06.05.2026**
(21) Application number: 17838915.1
(22) Date of filing: 26.03.2017
(51) Int. Cl.: G01R 33/383, H01F 7/02, G01R 33/421

(54) **MAGNETIC FIELD DEVICE FOR MRI/NMR AND METHOD OF PROVIDING THE DEVICE**
MAGNETFELDGERÄT FÜR MRI/NMR UND VERFAHREN ZUR BEREITSTELLUNG DES GERÄTS
DISPOSITIF A CHAMP MAGNETIQUE POUR IRM/RMN ET PROCÉDÉ DE FOURNITURE DU DISPOSITIF

(30) Priority: 08.08.2016 US 201662372065 P; 10.01.2017 US 201715402438
(43) Date of publication of application: 19.06.2019
(73) Proprietor: Aspect Imaging Ltd., 6085001 Shoham (IL)
(72) Inventor: RAPOPORT, Uri, 7311500 Ben Shemen (IL); GOLDFARB, Yair, 7408520 Ness-Zionna (IL); COHEN, Yoram, 4591500 Yarkona (IL)
(74) Representative: Forresters IP LLP
(86) International application number: PCT/IL2017/050371
(87) International publication number: WO 2018/029666

(56) References cited:
- JP-A- 2004 113 455
- JP-A- S62 139 304
- US-A- 3 534 251
- US-A- 4 937 545
- US-A- 5 635 889
- US-A1- 2009 072 939

## Description

### FIELD OF THE INVENTION

Generally, the present invention relates to magnetic devices. More particularly, the present invention relates to devices, systems and methods for obtaining magnetic measurements.

### BACKGROUND OF THE INVENTION

Electromagnetic based instruments can be used for measuring properties of matter and/or used for identifying its composition. For example, an electromagnetic based instrument capable of performing magnetic resonance spectroscopy can be used to obtain physical, chemical and/or structural information about matter (e.g., a molecule). Typically, in order to perform magnetic resonance spectroscopy, for example to provide high quality measurements of an object/subject (e.g., high resolution image and/or image contrast), it can be desirable for the magnetic field inside of a zone of measurement (e.g., an area where an object is to be measured is positioned) to be substantially stable and/or uniform. Other applications (e.g., magnetic resonance imaging (MRI)) can also require a high, stable, and/or uniform magnetic field strength.

Some systems that use magnetic fields for measurements can include magnetic coils to create the magnetic fields, with application of current to the coil, while other systems can utilize permanent magnets to create the magnetic fields, which typically do not require application of a current.

One difficulty in creating a magnetic field in a zone of measurement with permanent magnet(s) that is sufficient for magnetic resonance spectroscopy and/or magnetic imaging (e.g., that is substantially stable and/or uniform) is that magnetic fields produced by the permanent magnets(s) can be non-homogeneous, thus typically resulting in a non-homogenous magnetic field within the zone of measurement.

Some current solutions for creating a homogenous and/or stable magnetic field within a zone of measurement using a permanent magnet can include adding additional elements to an imaging device (e.g., coils) and/or increasing the size of the permanent magnets. One difficulty with current solutions is that as the number of elements in a magnetic measurement device increases and/or the size of the permanent magnets increases, the weight, size and/or cost of the device can increase.

Another difficulty with current solutions is that a magnetic measurement device that is heavy can cause a lack of mobility. For example, for magnetic measurement devices in a hospital setting (e.g., magnetic resonance imaging (MRI) devices), a heavy and/or large device can prevent hospital personnel from moving an MRI. This can cause further difficulties, when imaging patients that can be hard to move (e.g., patients that are hooked up to multiple life support and/or monitoring equipment).

In another example, for magnetic measurement devices in an industrial setting (e.g., nuclear magnetic measurement (NMR) devices that measure properties of fluids and/or drilling muds in oil production facilities), a heavy and/or large device can prevent personnel from measuring the fluids/muds at various locations in the processes.

Therefore it can be desirable to achieve a desired magnetic field strength, having sufficient homogeneity and/or stability, and/or reducing a total weight of a magnetic measurement system.
US4937545A discloses a system of permanent magnets having a permeable magnetic yoke formed by two opposite support walls and connected by two connecting walls, two main permanent magnets of the same magnetization direction disposed on the support walls within the yoke and whereof the facing surfaces carry opposite poles, two permeable magnetic plates on the facing surfaces and which define an air gap and two lateral permanent magnets whose magnetization direction is opposite to that of the main permanent magnets and which also define the air gap, being positioned facing the connecting walls and within the yoke, characterized in that the lateral permanent magnets extend laterally between the permeable magnetic plates, so as to be positioned facing the lateral edges of the main permanent magnets and the permeable magnetic plates.
JP2004113455A discloses a device which seeks to provide a magnetic field generating device capable of enhancing the intensity of a center magnetic field by suppressing a leak magnetic field while suppressing an increase in the weight of the device itself. This magnetic field generating device includes a device body formed into an annular shape using a plurality of permanent magnets so as to have a magnetic field generating space. Shield members with a thickness of 5 - 35 mm are provided to the outer periphery of the device body so as to be separated from the surfaces of the permanent magnets by 0 - 35 mm. The shield members have a saturated magnification of 1.5T or more. Insertion members with a saturated magnification of 0.2T or less are provided between the permanent magnets and the shield members.
JPS62139304A discloses a device which seeks to make the lines of magnetic force uniform over a wide range of area in an air gap by a method wherein an auxiliary magnet is arranged at the end part of a pole piece, and it is magnetized in the direction reverse to the lines of magnetic force of the air gap. A box type yoke is formed with soft iron yokes. Main magnets and pole pieces are arranged inside the yokes respectively. Said main magnets are magnetized in the direction as shown by the arrow M in the diagram, and the pole piece becomes N-pole and the pole piece becomes S-pole. Besides, an auxiliary magnet, magnetized in the direction reverse to the direction of the magnetic field in the magnetic gap, is arranged on the end part of the pole pieces. According to this constitution, the deterioration in magnetic field strength can be prevented as the lines of magnetic force is absorbed by the yoke at the end part of the pole pieces even when the intervals of the pole pieces is made wider, and the lines of magnetic force is made uniform in the air gap over a wide range.

### SUMMARY OF THE INVENTION

The present invention relates to a magnetic field device for performing magnetic field analysis of an object positioned within a gap of the device by using magnetic resonance imaging or nuclear magnetic resonance as defined in claim 1. A further aspect of the invention relates to a method of directing magnetic fields into a measurement volume as defined in claim 11. Further aspects of the invention are defined in the appended dependent claims.

There is thus provided a magnetic field device, including a first magnet, a first ferromagnetic element positioned adjacent to the first magnet, a second magnet, a second ferromagnetic element positioned adjacent to the second magnet and relative to the first ferromagnetic element to create a gap between the first ferromagnetic element and the second ferromagnetic element, and a third magnet positioned between the first ferromagnetic element and the second ferromagnetic element and within the gap.

In some arrangements, the third magnet has a first surface that faces a first surface of the first ferromagnetic element and a second surface that faces a first surface of the second ferromagnetic element. In some arrangements, the first surface of the third magnet abuts the first surface of the first ferromagnetic element and the second surface of the third magnet abuts the first surface of the first ferromagnetic element. In some arrangements, the third magnet has a dimension that allows the third magnet to translate between a first position and a second position, the first position being the first surface of the first ferromagnetic element, the second position being the first surface of the second ferromagnetic element

In some arrangements, the magnetic field device further includes a fourth magnet positioned between the first ferromagnetic element and the second ferromagnetic element and within the gap. In some arrangements, the fourth magnet has a first surface that faces a first surface of the first ferromagnetic element and a second surface that faces a first surface of the second ferromagnetic element. In some arrangements, the fourth magnet has a dimension that allows the fourth magnet to translate between a first position and a second position, the first position being the first surface of the first ferromagnetic element, the second position being the first surface of the second ferromagnetic element

In some arrangements, the first magnet, the second magnet and the third magnet are permanent magnets, superconducting magnets, or resistive magnets. In some arrangements,the first magnet, the second magnet and the third magnet have dimensions that are based on a desired magnetic field strength, a type of object to be imaged, or any combination thereof. In some arrangements, the first magnet, the second magnet and the third magnet has a length between 10 and 1100 millimeters, a width between 10 and 300 millimeters, and a height between 45 and 200 millimeters.

In some arrangements, the gap has dimensions that are based on a type of object to be imaged. In some arrangements, the gap has a diameter of 190 millimeters. In some arrangements, the magnetic field device further includes at least one fifth magnet coupled to the first magnet.

In some arrangements, the third magnet is positioned to cause a decrease of a magnetic field that is peripheral to the magnetic field device. A first axis of the magnetic field device is defined as passing from the first ferromagnetic element to the second ferromagnetic element, wherein the first magnet and the second magnet are positioned to cause a magnetic field with a magnetization direction along the first axis, and wherein the third magnet is positioned to cause a magnetic field with a magnetization direction along the first axis.

The magnetization direction of the third magnet is opposite of the magnetization direction of the first magnet. The magnetic field device is positioned within an outer shell, in some arrangements, the outer shell including a metal alloy. In somearrangements,at least one of the first and second magnets emits a magnetic field with a predetermined magnetic field strength, wherein the third magnet emits a magnetic field with a predetermined magnetic field strength, and wherein the strength of the magnetic field of at least one of the first and second magnets is substantially greater than the strength of the magnetic field of the third magnet. In some embodiments the total magnetic field produced during operation of the magnetic field device is substantially homogeneous and uniform within the gap

There is thus provided, in accordance with some described arrangements, a method of directing magnetic fields into a measurement volume, according to claim 11.

In some arrangements, the method further includes directing a third magnetic field into the measurement volume in a third direction, wherein the third direction is perpendicular to the first direction. In some arrangements, the method further includes positioning an object within the measurement volume, and performing magnetic field analysis on the object.

In some arrangements, at least one of the first magnetic field strength, and the second magnetic field strength is between 0.5 and 1.5 Tesla. In some arrangements, the first magnetic field strength and the first direction, and the second magnetic field strength and the second direction are based on a size of the measurement volume, a type of object to be measured, or any combination thereof. In some arrangements, the total magnetic flux in the measurement volume is a substantially homogeneous field.

There is further provided a shell positioned at a predetermined distance from the first magnet and the second magnet, to envelop at least the first magnet and the second magnet, wherein the predetermined distance is based on the desired magnetic field strength, and wherein thickness of the shell corresponds to the predetermined distance.

In some arrangements, the method further includes determining a distance to position a shell from the measurement volume that can generate the first magnetic field strength and the second magnetic field strength based on the size of the measurement volume , wherein positioning the shell at the distance from the measurement volume substantially eliminates a magnetic field outside of the shell.

### BRIEF DESCRIPTION OF THE DRAWINGS

The subject matter regarded as the invention is particularly pointed out and distinctly claimed in the concluding portion of the specification. The invention, however, both as to organization and method of operation, together with objects, features, and advantages thereof, can be understood by reference to the following detailed description when read with the accompanying drawings in which:
Fig. 1A schematically illustrates a perspective cross-sectional view of a magnetic field device, according to illustrative embodiments of the invention;
Fig. 1B schematically illustrates a perspective cross-sectional view of a magnetic field device having additional magnets to the device of Fig. 1A, according to illustrative embodiments of the invention;
Fig. 2A schematically illustrates a frontal cross-sectional view of the magnetic field device, according to illustrative embodiments of the invention;
Fig. 2B schematically illustrates a frontal cross-sectional view of the magnetic field device, with additional magnets, according to illustrative embodiments of the invention
Fig. 3 shows a flow chart for a method of directing magnetic fields into a measurement volume, according to illustrative embodiments of the invention;
Figs. 4A-4H schematically illustrate top cross-sectional views of various magnetic field devices, according to illustrative embodiments of the invention;
Fig. 5A schematically illustrates a frontal cross-sectional view of a magnetic field device, according to illustrative embodiments of the invention;
Fig. 5B schematically illustrates a frontal cross-sectional view of a magnetic field device, according to illustrative embodiments of the invention;
Fig. 6 schematically illustrates a frontal cross-sectional view of a head magnetic field device, according to illustrative embodiments of the invention;
Fig. 7 shows a graph of magnetic fringe field as a function of distance from magnets to the shell, according to illustrative embodiments of the invention; and
Fig. 8 shows a flow chart for a method of directing magnetic fields into a measurement volume, according to illustrative embodiments of the invention.

It will be appreciated that for simplicity and clarity of illustration, elements shown in the figures have not necessarily been drawn to scale. For example, the dimensions of some of the elements can be exaggerated relative to other elements for clarity. Further, where considered appropriate, reference numerals can be repeated among the figures to indicate corresponding or analogous elements.

### DETAILED DESCRIPTION OF THE INVENTION

In the following detailed description, numerous specific details are set forth in order to provide a thorough understanding of the invention. However, it will be understood by those skilled in the art that the present invention can be practiced without these specific details. In other instances, well-known methods, procedures, and components have not been described in detail so as not to obscure the present invention.

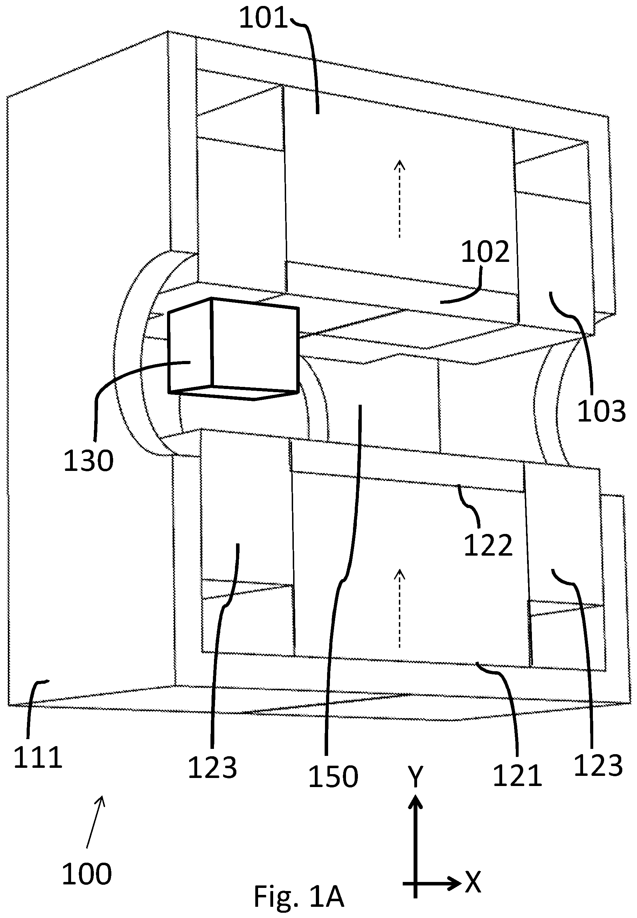

Fig. 1A schematically illustrates a cross-sectional perspective view of a magnetic field device 100, according to illustrative embodiments of the invention. The magnetic field device 100 includes an outer shell 111, a first magnet 101 (e.g., a first permanent magnet), a first ferromagnetic element 102 (e.g., a first pole piece), and a second magnet 121 (e.g., a second permanent magnet) and a second ferromagnetic element 122 (e.g., a second pole piece). In some embodiments, first magnet 101 and first ferromagnetic element 102 and/or second magnet 121 and second ferromagnetic element 122 can be grouped together as a single unit (e.g., as an assembly).

The first ferromagnetic element 102 can be coupled to and is positioned adjacent to the first magnet 101. The second ferromagnetic element 122 can be coupled to and is positioned adjacent to the second magnet 121. The magnetic field device 100 includes a third magnet 130, positioned between the first ferromagnetic element 102 and the second ferromagnetic element 122.

The first and second ferromagnetic elements 102, 122 can be coupled and are positioned adjacent to a corresponding first and second magnets 101, 121 such that the first and second ferromagnetic elements 102, 122 are proximal to a gap 150 (e.g., zone of measurement) of the magnetic field device 100. The first magnet 101 and the second magnet 121 are distal to the gap 150 of the magnetic field device 100. The magnetization direction of the first magnet 101 is parallel to the magnetization direction of the second magnet 121, along the second axis (indicated "X" in Fig. 1A), where the first and second ferromagnetic elements 102, 122 face each other with the gap 150 created therebetween.

In various embodiments, dimensions of the gap 150 (and thus positioning on of the elements 102, 122, 101, 121) can depend on a subject/object to be measured. For example, if the subject to be measured is an adult human head gap 150 can have dimensions that comfortably fit an adult human head. In another example, if the subject to measured is a mouse, gap 150 can fit the mouse. It is apparent to one of ordinary skill that other objects/subjects can be measured, and that these are examples.

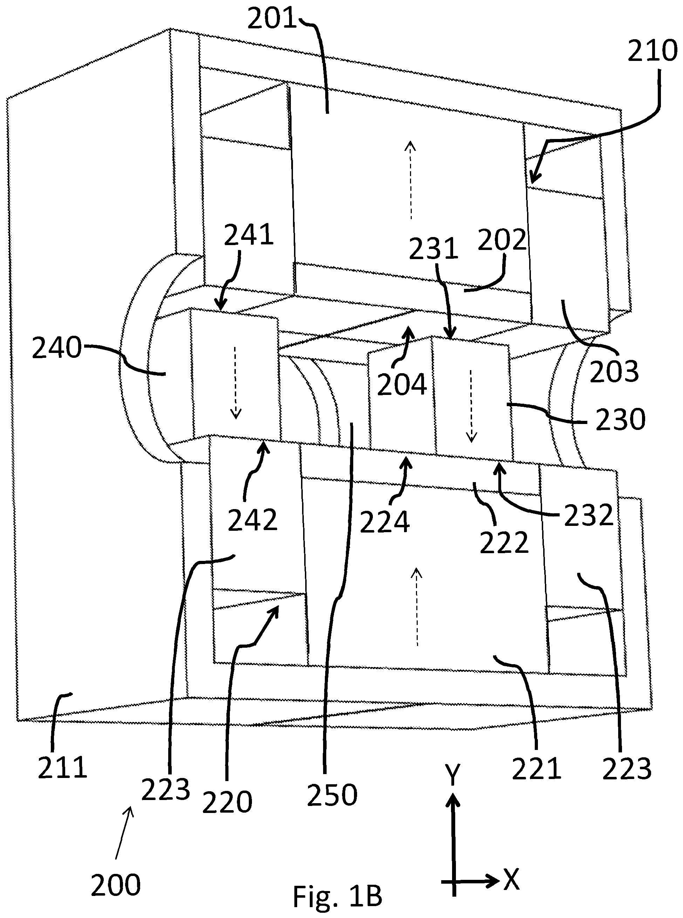

Fig. 1B schematically illustrates a cross-sectional perspective view of a magnetic field device 200, having additional magnets to the device of Fig. 1A, according to illustrative embodiments of the invention. The magnetic field device 200 includes an outer shell 211, a first magnet 201, a first ferromagnetic element 202 (e.g., a first pole piece), a second magnet 221, a third magnet 230, a fourth magnet 240, a first ferromagnetic element 202, and a second ferromagnetic element 222 (e.g., a second pole piece). The first ferromagnetic element 202 can be coupled to and is positioned adjacent to the first magnet 201. The second ferromagnetic element 222 can be coupled to and is positioned adjacent to the second magnet 221.

The magnetic field device 200 includes additional magnets such as magnets 103, 123 in Fig. 1A or magnets 203, 223 in Fig. 1B.

The first and second ferromagnetic elements 202, 222 can be coupled to and are positioned adjacent to its corresponding first and second magnets 201, 221 such that the first and second ferromagnetic elements 202, 222 are proximal to a gap 250 (e.g., zone of measurement) of the magnetic field device 200. The first magnet 201 and the second magnet 221 are distal to the gap 250 of the magnetic field device 200. The magnetization direction of the first magnet 201 is parallel to the magnetization direction of the second magnet 221, along the second axis (indicated "X" in Fig. 1B), where the first and second ferromagnetic elements 202, 222 face each other with the gap 250 created therebetween.

The third magnet 230 can be coupled to and is positioned between the first ferromagnetic element 202 and the second ferromagnetic element 222.

The third magnet 230 can have a first surface 231 that faces a first surface 204 of the first ferromagnetic element 202 and a second surface 232 that faces a first surface 224 of the second ferromagnetic element 222. The first surface 231 of the third magnet 230 can abut the first surface 204 of the first ferromagnetic element 202 and the second surface 232 of the third magnet 230 can abut the first surface 224 of the first ferromagnetic element 220. In some embodiments, the third magnet 230 can have a dimension that allows the third magnet 230 to translate between a first position and a second position, the first position being the first surface 204 of the first ferromagnetic element 202, the second position being the first surface 224 of the second ferromagnetic element 222.

The fourth magnet 240 can be positioned between the first ferromagnetic element 202 and the second ferromagnetic element 222 and within the gap 250. The fourth magnet 240 can have a first surface 241 that faces the first surface 204 of the first ferromagnetic element 202 and a second surface 242 that faces the first surface 224 of the second ferromagnetic element 222. The fourth magnet 240 can have a dimension that allows the fourth magnet 240 to translate between a first position and a second position, the first position being the first surface 204 of the first ferromagnetic element 202, the second position being the first surface 224 of the second ferromagnetic element 222.

As is apparent to one of ordinary skill in the art, while magnetic gradient coils (creating a magnetic field with application of current) can be utilized in the gap to provide a magnetic gradient, an embodiment of the invention uses permanent magnets that have no need for magnetic gradient coils.

In some embodiments, the first magnet 201, the second magnet 221 and the third magnet 230 are permanent magnets and/or superconducting magnets and/or resistive magnets. The first magnet 201, the second magnet 221 and the third magnet 230 can have dimensions that are based on a desired magnetic field strength, a type of object to be imaged, or any combination thereof.

In some embodiments, at least one of the first magnet 201, the second magnet 221 and the third magnet 230 has a length between 10 and 1100 millimeters, a width between 10 and 300 millimeters, and a height between 45 and 200 millimeters.

Each of the magnets of magnetic field device 200 has a direction of magnetization and creates a magnetic field. The dashed arrows in Fig. 1B indicate a direction of the magnetization of the particular magnet the arrow is displayed on.

The first magnet 201 and second magnet 221 have the same magnetization direction along a first axis (indicated "Y" in Fig. 1B), for example a transverse axis of the magnetic field device 200.

The magnetization direction of the third magnet 230 is opposite to the magnetization direction of the first and second magnets 201, 221 for instance along the first axis (indicated "Y" in Fig. 1B).

In some embodiments, the first ferromagnetic element 202 and the second ferromagnetic element 222 can extend and can direct the magnetic field produced by the corresponding first magnet 201 and second magnet 221, and/or reduce noise from outside of the magnetic field device 200.

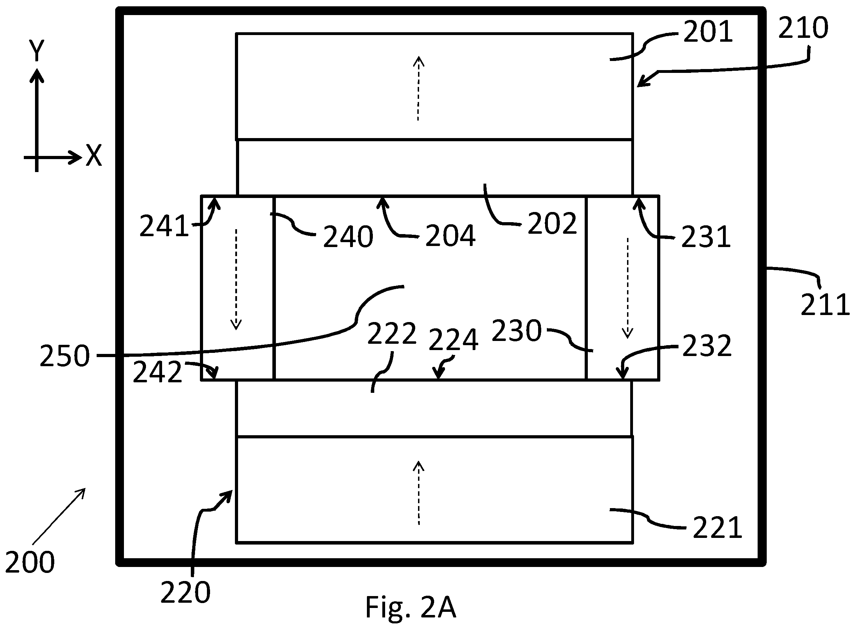

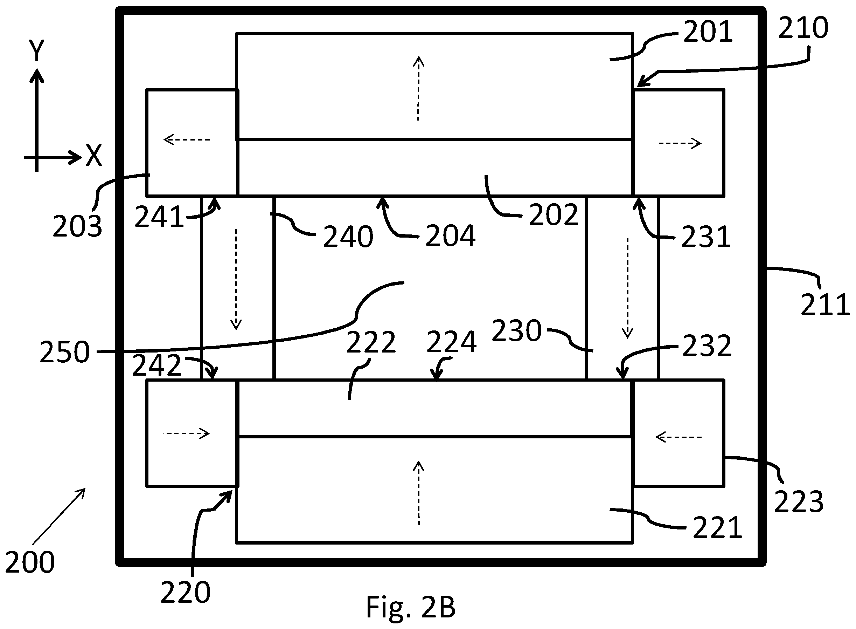

Fig. 2A schematically illustrates a frontal cross-sectional view of the magnetic field device 200, according to illustrative embodiments of the invention. Fig. 2B schematically illustrates a frontal cross-sectional view of the magnetic field device 200, with additional magnets, according to illustrative embodiments of the invention.

In some embodiments, the magnetic field device 200 can include additional magnets. Turning to FIG. 2B, the magnetic field device 200 includes a fifth magnet 203, and a sixth magnet 223. In some embodiments a t least one of fifth magnet 203 and sixth magnet 223 is a permanent magnet.

The magnetic field device 200 includes additional magnets 203, 223 while the third magnet 230 can be coupled to the first and second ferromagnetic elements 202, 222.

The fifth and sixth magnets 203, 223 are positioned around the first and second magnets 201, 221, respectively, the sixth magnet 223 is positioned around the second magnet 221.

The fifth and sixth magnets 203, 223 have a magnetization direction perpendicular to the magnetization direction of the first magnets 201 along a second axis (indicated "X" in Fig. 2B) perpendicular to the first axis, for example a longitudinal axis of the magnetic field device 200. The magnetization direction of the at least one fifth magnet 203 is away from the first magnet 201, and the magnetization direction of the at least one sixth magnet 223 is towards the second magnet 221.

As is apparent to one of ordinary skill in the art, additional magnets can be included in the magnetic field device 200. For example, in some embodiments, additional third magnets, fifth magnets and/or first magnets can be used.

In some embodiments, the outer shell 211 can include a metal alloy, and can allow confining (or substantially confining) the magnetic field created by the magnets of magnetic field device 200 within the outer shell 211. In this manner, the existence of a magnetic field outside of the outer shell 211 can be zero and/or negligible. For example, if a device that is susceptible to the effects of a magnetic field (e.g., cell phone, pacemaker, etc.) is positioned adjacent to the outer shell 211 outside of the device 200, the magnetic field in that location can have a negligible effect on the device. In some embodiments, outer shell 111 can also have an opening so as to provide access to the gap 250.

In various embodiments, the third magnet 230 and/or the fourth magnet 240 can have a hollow structure and surround the gap 250 between the first and second ferromagnetic elements 202, 222. In various embodiments, the third magnet 230 and/or the fourth magnet 240 can be provided in a variety of shapes and sized, for instance cylindrical or triangular, with varying shape and size.

In case that magnetic field device 200 is utilized for magnetic resonant imaging, additional electromagnetic elements can be included, such as a radio frequency (RF) generator or field sensors. The third magnet 230 can be configured to surround the gap 250 between the first and second ferromagnetic elements 202, 222 in order to for example, prevent radiation leakage from additional electromagnetic elements, for instance RF generator in magnetic resonance devices. For example, third magnet 230 can be in a shape of a hollow cube or a hollow cylinder surrounding gap 250 in order to, for example, prevent radiation leakage from additional electromagnetic elements outside of third magnet 230.

The third magnet 230 can contribute to causing the overall magnetic field to be a homogeneous and/or uniform magnetic field, for magnetic field device 200 in the area of measurement. The third magnet 230 can allow for a reduction of size, weight, and/or magnetic field strength of the first and/or second magnets 201, 221 and/or the fifth and/or sixth magnets 203, 223 due to, for example, the third magnet 230 contributing to the overall magnetic field strength within the gap. A reduction in size of the first and/or second magnets 201, 221 and/or the fifth and/or sixth magnets 203, 223, can allow for a having lower weight of the magnetic field device with substantially the same field strength compared to, for example, a magnetic field device that does not include the third magnet 230.

In some embodiments, magnetic field device 200 includes two fifth magnets 203, and also includes two sixth magnets 223. In these embodiments, the ability to reduce the size of the magnets due to, for example, the third magnet 230 can provide even further weight reduction of the magnetic field device.

In some embodiments, at least one of the first and second magnets 201, 221 emits a magnetic field with a predetermined magnetic field strength, wherein the third magnet 230 can emit a magnetic field with a predetermined magnetic field strength, and wherein the strength of the magnetic field of at least one of the first and second magnets 201, 221 can be substantially greater than the strength of the magnetic field of the third magnet 230.

According to some embodiments, the outer shell 211 can constitute the main bulk of the weight of the magnetic field device 200. Since the addition of the third magnet 230 can reduce weight of other components as well as provide a homogeneous and uniform magnetic field, it can be possible to utilize an outer shell with reduced weight. In some embodiments, a reduction of at least twenty percent can be created for the total weight of the magnetic field device 200 in comparison to, for example, devices that do not have the third magnet. In some embodiments, an increase of at least thirty percent can be created for the magnetic field strength, for example in comparison to, for example, device that do not have the third magnet but have substantially the same total weight of the magnetic field device 200. The third magnet 230 can allow obtaining stronger magnetic fields and/or lower total magnet weight.

In some embodiments, the area of the fringe field can be reduced from the center of the gap, for example for a limit of a field of about 1Gauss (sometimes referred to as the 1G line) can be reduced at substantially 100millimeters. Therefore, reduction of fringe field can cause the dimensions of the outer shell 211 to be reduced, for example, from substantially 860x1032 millimeters to substantially 786x894 millimeters. Reduction of the outer shell 211 can accordingly cause a reduction of the total weight of magnetic field device 200.

Overall weight of a magnetic field device can be reduced, and for example an increase of over ten percent for the ratio of magnetic field strength to total weight of at least the combination of the first and second magnets and the at least one third magnet. In some embodiments, an increase in magnetic field caused by the third magnets can be larger than the increase that may be achieved by a corresponding enlargement of the first and second magnets (without a third magnet). This is due to the alignment of the third permanent magnets and also due to the scalability of the weight savings such that addition of magnets can cause a reduction of weight.

In some embodiments, the outer shell 211 can also have a smaller surface area compared to a commercially available magnetic resonance device, due to a reduction in fringe weight of the outer shell and/or due to reduction of the fringe field. Such reduction can occur since the addition of the third magnet 230 can increase magnetic field in the gap 250, between the first and second ferromagnetic elements 202, 222 and therefore reduce the fringe field of the magnetic field device 200 so that there is no longer a need for the outer shell 211 to be at same large weight and large surface area, for example compared to a commercially available magnetic resonance device.

In some embodiments, additional material, for example including Iron, can be added to magnetic field device 200 in order to further confine and manipulate the magnetic field in the gap. In some embodiments, the added material, for example including Iron and/or Titanium, can be added adjacent to at least one magnet 201 and/or adjacent to at least one ferromagnetic element 202.

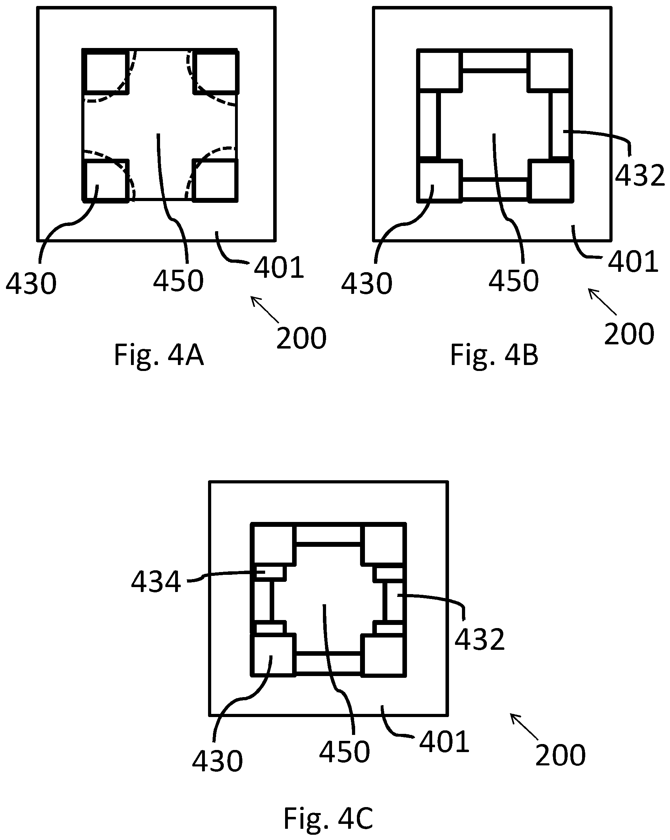

It may be appreciated that regions of high magnetic flux density causing external fringe fields can occur adjacent to connection of the magnets, e.g., indicated with a dashed line in Fig. 4A. In some embodiments, an outer shell (or envelope), usually including Iron, surrounds the magnetic resonance device to reduce the magnetic flux.

In some embodiments, the third magnet 230 can prevent at least a portion of magnetic flux from exiting a gap (e.g., an area where the magnetic field is directed). Magnetic field device 200 can be utilized in order to provide a strong magnetic field while providing reduced weight of the device, for example utilized for magnetic resonant imaging or for other devices where a strong magnetic field can be required. It may be appreciated that addition of the third magnets can counter the magnetic flux, for example in regions indicated with a dashed line in Fig. 4A, so as to, for example, reduce the fringe fields.

According to some embodiments, an existing magnetic field system that includes two magnets, neither of which includes a third magnet can be modified with insertion of at least one third magnet between the two magnets, in order to, for example, increase the magnetic field within the gap and/or reduce the fringe field. For example, a comparison between three systems: a first system "A" without third magnets, a second system "B" provided with at least one third magnet, and a third system "C" that is modified with the addition of at least one third magnet. In this example, in weight comparison to the first system "A", the second system "B" can have weight reduced at about 5.5%, while the third system "C" can have weight increase at about 6.5%. In this example, in comparison to the first system "A" of field strength in the gap, the second system "B" can have increase of about 15%, and the third system "C" can have increase of about 13%. In this example, in comparison to the first system "A" of fringe field reduction, the second system "B" can have decrease of about 55%, and the third system "C" can have decrease of about 16%. Therefore, in correct positioning of third magnets can provide various advantages to new systems as well as to existing systems that can be modified. It is apparent to one of ordinary skill in the art that the example provided above gives exemplary weight reduction values for explanatory purposes, and that other comparison weight configurations are within the scope of the invention.

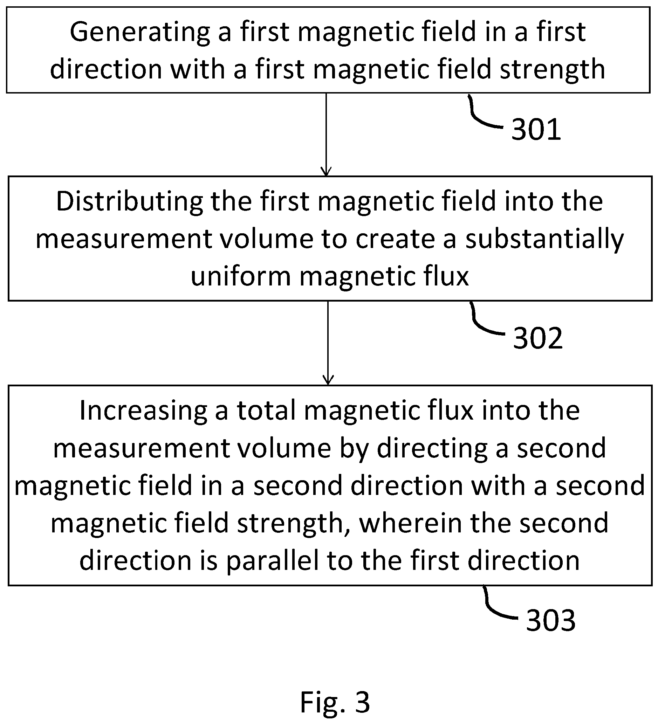

Reference is now made to Fig. 3, which shows a flow chart for the use of the inventive magnetic field device in a method of directing magnetic fields into a measurement volume, according to some embodiments of the invention.

The method includes generating a first magnetic field in a first direction with a first magnetic field strength (Step 301). For example, the first and second magnets 201 and 221 as described above in Fig. 1B can direct a first magnetic field in a first direction and having first magnetic field strength.

The method can further include distributing the first magnetic field into the measurement volume to create a substantially uniform magnetic flux. (Step 302). For example, the first ferromagnetic element 202 and/or the second ferromagnetic element 222, as described above in FIG. 1B can distribute the first magnetic field into the measurement volume.

The method can further include increasing a total magnetic flux into the measurement volume by directing a second magnetic field in a second direction with a second magnetic field strength, where the second direction is parallel to the first direction (Step 303). For example, the third magnet 230 as described above in Fig. 1 can direct a second magnetic field in a second direction and having second magnetic field strength. In some embodiments, the method includes directing a third magnetic field in a third direction having a third magnetic field strength, wherein the third direction is perpendicular to the first direction. For example, the fifth magnets 203 and/or sixth magnets 223 as described above in Fig. 2 can direct a third magnetic field in a third direction and having third magnetic field strength.

In some embodiments, the method includes positioning an object within the measurement volume, and performing magnetic field analysis on the object (e.g., by using the magnetic device 200 within a NMR device and/or an MRI device).

In some embodiments, first, second and third magnetic fields are directed such that a desired magnetic field strength is achieved. The desired magnetic field strength can be based on a particular device performing the measurements and/or object to be measured. For example, the desired magnetic field strength can be between 0.5-1.5T, for magnetic resonance imaging of living human tissue. As is apparent to one of ordinary skill in the art, the desired magnetic field strength shown is for exemplary purposes only, and that the desired magnetic field strengths can vary based on subject/application of the magnetic field.

In some embodiments, the first magnetic field strength and the first direction, and the second magnetic field strength and the second direction are based on a size of the measurement volume and/or type of object to be measured, and/or any combination thereof. In some embodiments, the total magnetic flux in the measurement volume can be a substantially homogeneous field.

Reference is now made to Figs. 4A-4H, which schematically illustrate a top cross-sectional view of some exemplary configurations for magnetic components of a magnetic field device (for example magnetic field device 200), according to some embodiments of the invention. Fig. 4A schematically illustrates a first exemplary configuration, where at least one third magnet 430 (similar to the third magnet 230, as shown in Figs. 1-2) can be positioned adjacent to the first magnet 401 (similar to the first magnet 201, as shown in Figs. 1-2), for example perpendicularly. Such positioning can be utilized to at least partially surround and/or envelope the gap 450 (similar to gap 250, as shown in Figs. 1-2). In some embodiments, a plurality of the third magnets 430 can be utilized, wherein each second magnet 430 (e.g., main magnets) can have a different size and/or shape. In some embodiments, the fifth and sixth magnets can be positioned such that they do not physically contact the third magnets.

Fig. 4B schematically illustrates a first exemplary configuration, where at least one first intermediate magnet 432 (e.g., main magnet) can be positioned between two adjacent third magnets 430. Fig. 4C schematically illustrates a first exemplary configuration, where at least one second intermediate magnet 434 e.g., main magnet) can be positioned between adjacent third magnet 430 and first intermediate magnet 432. In some embodiments, at least one of first intermediate magnet 432 and/or second intermediate magnet 434 can be a permanent magnet.

According to some embodiments, an object (or a subject) can be introduced to the gap (or measurement region), for example in order to adjust an element therein, from any one of four possible directions due to, for example, the symmetry of the system. In some embodiments, access can also be provided for introduction of cameras, air conditioning and/or other equipment to be adjacent to the gap.

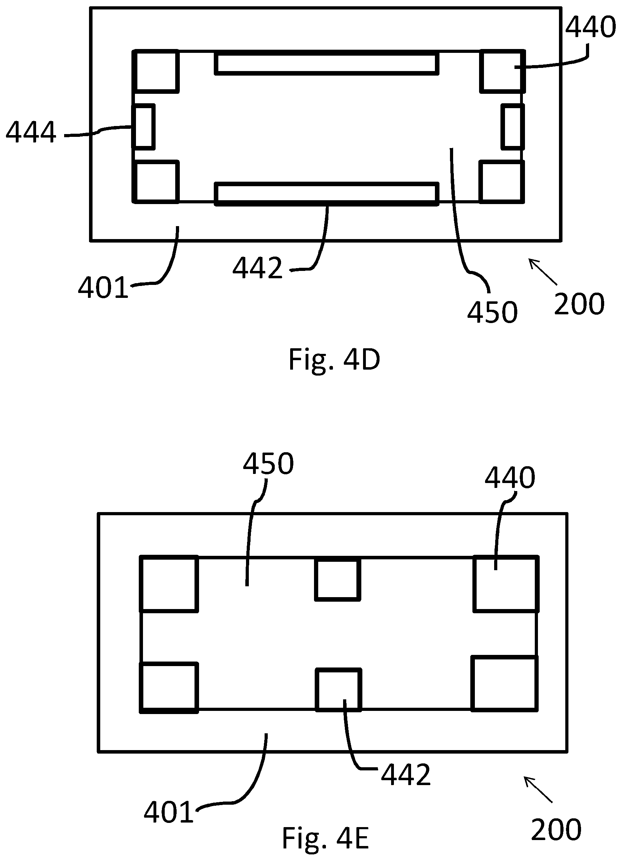

Fig. 4D schematically illustrates a first exemplary configuration, where at least one first intermediate magnet 442 can be positioned between two adjacent third magnets 440 and at least one second intermediate magnet 444 can be positioned between two adjacent third magnets 440. Different sizes and/or shapes of at least one first intermediate magnet 442 and at least one second intermediate magnet 444 can allow differentiation of the magnets, e.g., providing smaller magnets of different shapes at particular locations instead of single large magnet, in order to allow a desired magnetic flux within the gap 450. In case that shape symmetry about an axis through the center of the third magnet is broken, e.g., for magnetic shimming and/or for creation of an opening to allow access to the gap, other elements (e.g., permanent magnets) can be modified so as to maintain the predetermined magnetic field. In some embodiments, a break in symmetry, e.g., of the shape of the magnet, can require modification of the outer shell as well.

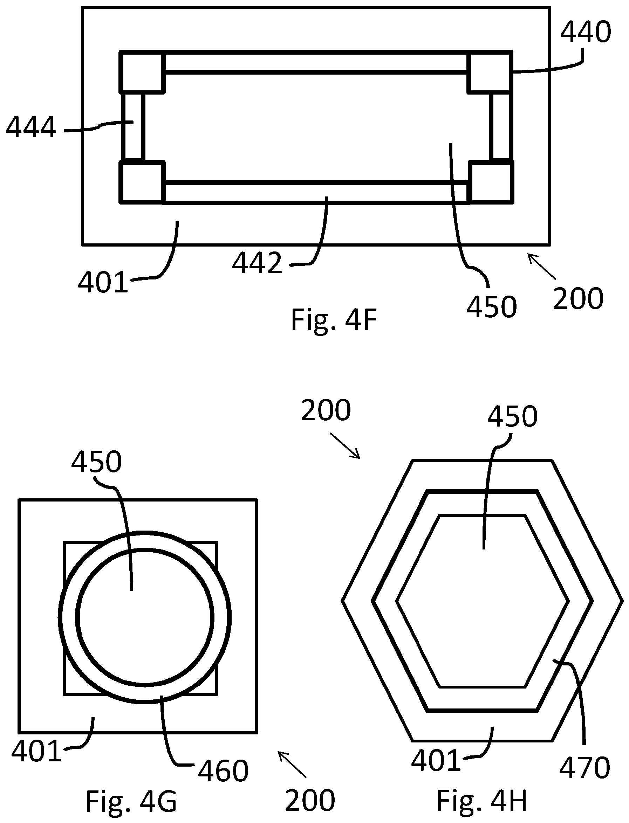

Fig. 4E schematically illustrates a first exemplary configuration, where at least one first intermediate magnet 442 can be positioned at a predetermined distance, based on the predetermined magnetic field strength, from the center of first magnet 401, in order to allow a desired magnetic flux within the gap 450. Fig. 4F schematically illustrates a first exemplary configuration, where at least one first intermediate magnet 442 can be positioned between two adjacent third magnets 440 and at least one second intermediate magnet 444 can be positioned between two adjacent third magnets 440. In some embodiments, addition of the at least one first intermediate magnet 442 can be configured to further support the structure of the system and/or to create at least a partial magnetic cage within the gap 450.

Fig. 4G schematically illustrates a first exemplary configuration, where a circularly shaped third magnet 460 can surround the gap 450. Fig. 4H schematically illustrates a first exemplary configuration, where or a hexagon shaped third magnet 470 can surround the gap 450. In some embodiments, an opening can be provided in a third magnet surrounding the gap 450 in order to allow insertion of an object therein.

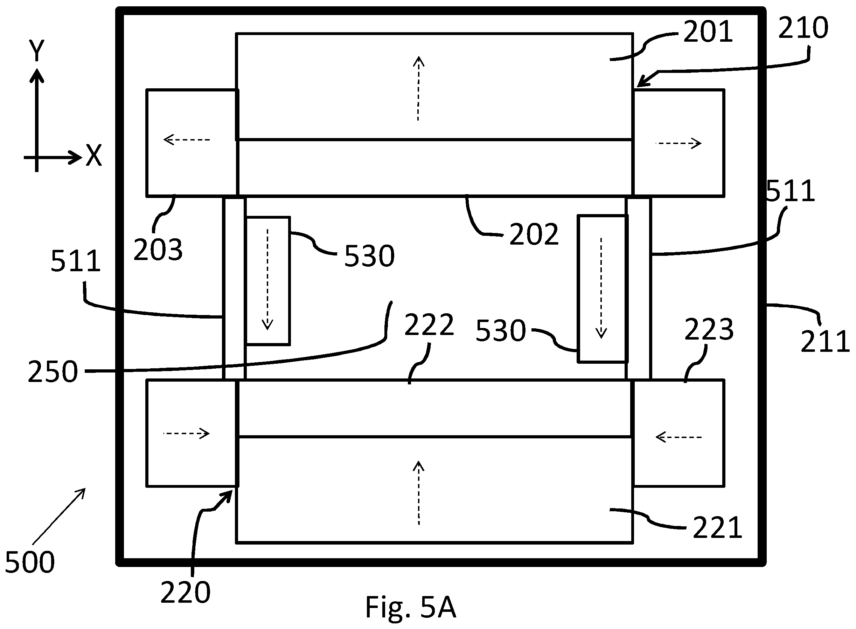

Reference is now made to Figs. 5A-5B, which show the magnetic field device 500 (e.g., magnetic field device 200 as described above in FIG. 2) including support elements. Fig. 5A schematically illustrates a frontal cross-sectional view of a magnetic field device 500 having first support elements 511, according to some embodiments of the invention. It may be appreciated that the magnetic field device 500 can include all elements of the magnetic field device 200 (e.g., as shown in Figs. 1-2) with the addition of at least one first support element 511 between the first ferromagnetic element 202 and the second ferromagnetic element 222.

According to some embodiments, at least one third magnet 530 can be added to a first support element 511 such that at least one air gap (not shown) can be created between the third magnet 530 and the first and/or second magnets 201, 221. In some embodiments, instead of air gaps, a gap of diamagnetic material can be formed therein.

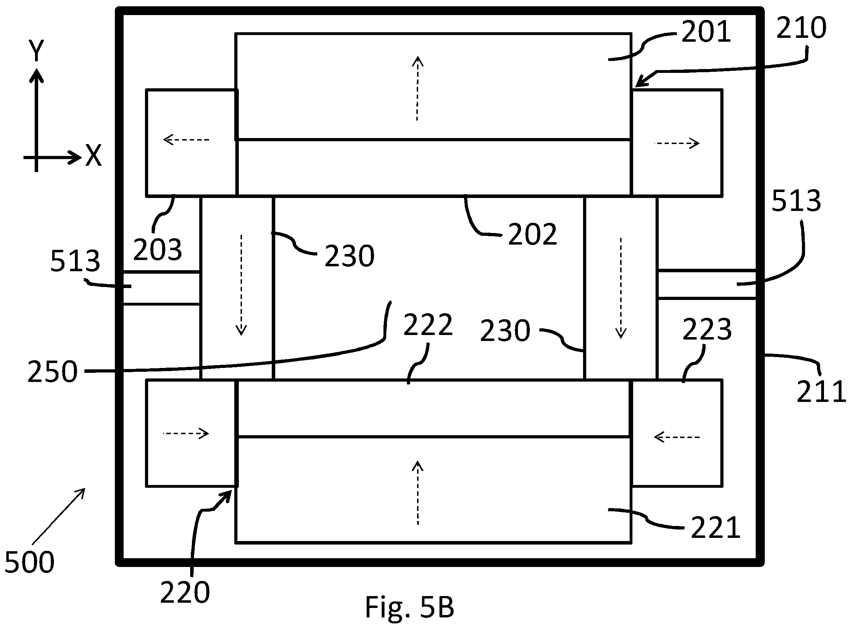

Fig. 5B schematically illustrates a frontal cross-sectional view of a magnetic field device 500 having second support elements 513, according to some embodiments of the invention. It may be appreciated that the magnetic field device 500 can include all elements of the magnetic field device 200 (e.g., as shown in Figs. 1-2) with the addition of at least one second support element 513. In some embodiments, the outer shell 211 (or envelope) can contact at least one third magnet 230 with at least one second support element 513 in order to support the positioning of the third magnets 230. It may be appreciated that such support of third magnets 230 can counter magnetic attraction forces acting on third magnets 230, such that third magnet 230 can remain in the desired position. In some embodiments, the at least one second support element 513 can couple the third magnets 230 with at least one of the outer shell 211 and first and second ferromagnetic elements 202, 222.

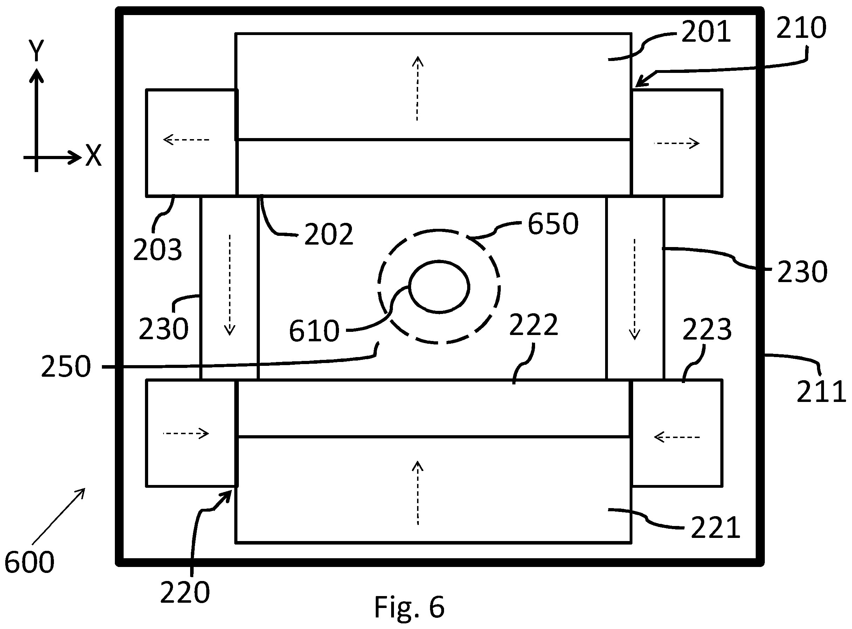

Reference is now made to Fig. 6, which schematically illustrates a frontal cross-sectional view of a head magnetic field device 600, according to some embodiments of the invention. The head magnetic field device 600 includes a first magnet 201 and a first ferromagnetic element 202 coupled to the first magnet 201, and a second magnet 221 and a second ferromagnetic element 222 coupled to the second magnet 221. The first magnet 201and the second magnet 221 can be positioned to create a gap 250 therebetween, with the first ferromagnetic element 202 and the second ferromagnetic element 222 positioned adjacent the gap 250 and between the gap 250 and a respective first magnet 201 and second magnet 221. The head magnetic field device 600 can also include an opening 650, the opening configured to allow, for example, at least partial accommodation of a head 610 of a patient within the gap 250 (or measurement volume).

The head magnetic field device 600 also includes at least one third magnet 230. It may be appreciated that while the head 610 of the patient is described here, any other body part can be similarly introduced to the gap 250 for inspection, for example and arm or a leg.

In some embodiments, magnetic resonance imaging elements (e.g., RF coil) can be coupled to the head magnetic field device 600 in order to allow imaging the head 610 of the patient within the gap 250. In an exemplary embodiment, the magnetic field strength for such a head magnet is above 4900 Gauss or about 4988 Gauss. In an exemplary embodiment, the field of view for MRI imaging within the gap 250 is a sphere with a diameter of about 190 millimeters. In an exemplary embodiment, the diameter of the opening 650 to the gap 250 is above 660 millimeters or about 665 millimeters. In an exemplary embodiment, the dimensions for a permanent head magnet are 1226x1226x866 millimeters.

According to some embodiments, the distance between the outer shell and the magnets can be modified to achieve a modified magnetic field. In some embodiments, the thickness of the outer shell can be modified in accordance with changes in the distance between the outer shell and the magnets.

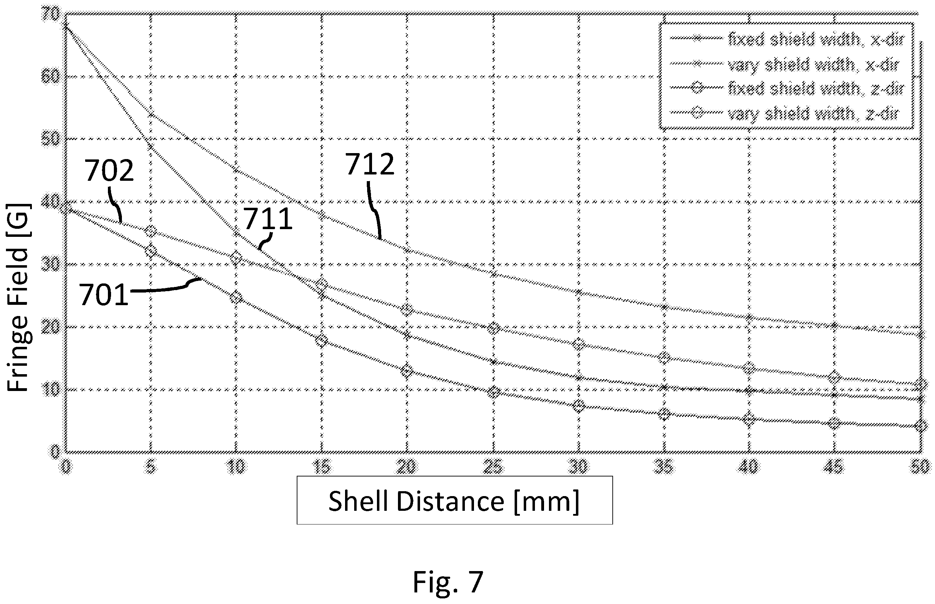

Reference is now made to Fig. 7, which shows a graph of magnetic fringe field as a function of distance from magnets to the shell, according to some embodiments of the invention. The change in magnetic fringe field as a function of distance of the shell from the magnets (enveloped by the shell) is shown for constant and varying thickness of the shell, for example shell 211 as shown in Fig. 1B. In some embodiments, the thickness of the shell can be changes such that the total weight of the magnetic field device (including the shell and the magnets) can be reduced.

The shell is positioned in a predetermined distance from the magnets, where the predetermined distance can be based on the desired magnetic field strength. The thickness of the shell corresponds to the predetermined distance. It may be appreciated that changing the distance between the shell and the magnets can also reduce the fringe field.

In some embodiments, the thickness of the shell inversely corresponds to the predetermined distance, such that the thickness decreases with increased distance between the shell and the magnets. In some embodiments, the thickness of the shell is based on the predetermined distance exceeding a predetermined threshold. In some embodiments, the predetermined distance is also based on the weight of the at least one magnet. In some embodiments, the predetermined distance is 50 millimeters.

A first curve 701 corresponds to constant thickness of the shell with change in the distance for a fringe field along the 'Y' axis as shown in Fig. 1B. If the thickness of the outer shell is reduced to a predetermined thickness while distance of the shell from the magnets is increased, then the total weight of the magnetic field device can be maintained. A second curve 702 corresponds to varying thickness of the shell with change in the distance for a fringe field along the 'Y' axis as shown in Fig. 1B. A third curve 711 corresponds to constant thickness of the shell with change in the distance for a fringe field along the 'X' axis as shown in Fig. 1B. A fourth curve 712 corresponds to varying thickness of the shell with change in the distance for a fringe field along the 'X' axis as shown in Fig. 1B.

As can be apparent to one of ordinary skill in the art, the fringe field is reduced with distancing of the outer shell, and at a distance of about 50 millimeters there is a substantial decrease in magnetic fringe field for all curves. Thus, a reduced magnetic fringe field can be achieved by changing the distance between the shell and the magnets.

According to some embodiments, the magnetic field within the measurement volume is substantially unaffected by the reduction of the fringe field caused by the increased distance between the shell and the magnets.

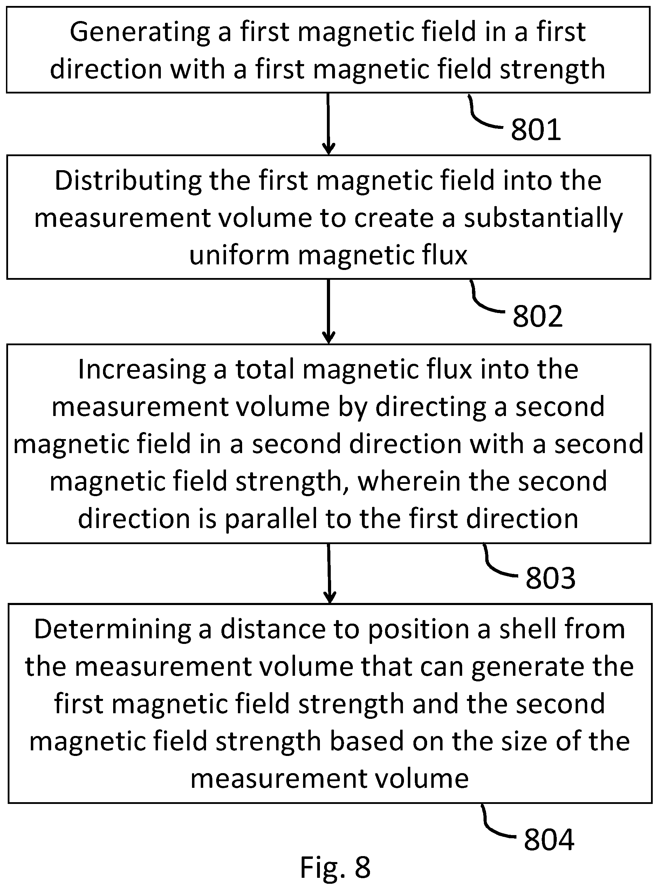

Reference is now made to Fig. 8, which shows a flow chart for a method of using the inventive magnetic field device for directing magnetic fields into a measurement volume, according to some embodiments of the invention.

The method includes generating a first magnetic field in a first direction with a first magnetic field strength (Step 801). For example, the first and second magnets 201 and 221 as described above in Fig. 1B can direct a first magnetic field in a first direction and having first magnetic field strength.

The method can further include distributing the first magnetic field into the measurement volume to create a substantially uniform magnetic flux (Step 802). For example, the first ferromagnetic element 202 and/or the second ferromagnetic element 222, as described above in FIG. 1B can distribute the first magnetic field into the measurement volume.

The method can further include increasing a total magnetic flux into the measurement volume by directing a second magnetic field in a second direction with a second magnetic field strength, wherein the second direction is parallel to the first direction (Step 803). For example, the third magnet 230 as described above in Fig. 1 can direct a second magnetic field in a second direction and having second magnetic field strength. In some embodiments, the method includes directing a third magnetic field in a third direction having a third magnetic field strength, wherein the third direction is perpendicular to the first direction. For example, the fifth magnets 203 and/or sixth magnets 223 as described above in Fig. 2 can direct a third magnetic field in a third direction and having third magnetic field strength.

The method can further include determining a distance to position a shell from the measurement volume that can generate the first magnetic field strength and the second magnetic field strength based on the size of the measurement volume, wherein positioning the shell at the distance from the measurement volume substantially eliminates a magnetic field outside of the shell (Step 804). For example, determining a distance to position the shell from the measurement volume such that the magnetic field outside of the shell is lower than a predetermined threshold.

In some embodiments, the method can further include reducing the thickness of the shell if the predetermined distance exceeds a predetermined threshold. In some embodiments, the method can further include decreasing the weight of the at least one magnet if the predetermined distance exceeds a predetermined threshold, and maintaining the desired magnetic field strength. In some embodiments, the predetermined distance is also based on strength of the fringe magnetic field.

Unless explicitly stated, the method embodiments described herein are not constrained to a particular order in time or chronological sequence. Additionally, some of the described method elements can be skipped, or they can be repeated, during a sequence of operations of a method.

Various embodiments have been presented. Each of these embodiments can of course include features from other embodiments presented, and embodiments not specifically described can include various features described herein, provided they fall under the scope of the appended claims.

## Claims

1. A magnetic field device (100, 200) for performing magnetic field analysis of an object positioned within a gap of the device (100, 200) by using magnetic resonance imaging or nuclear magnetic resonance, the device (100, 200) comprising:
a first magnet (101, 201, 401);
a first ferromagnetic element (102, 202) positioned adjacent to the first magnet (101, 201, 401);
a second magnet (121, 221);
a second ferromagnetic element (122, 222) positioned adjacent to the second magnet (121, 221) and relative to the first ferromagnetic element (102, 202) to create the gap (150, 250, 450) between the first ferromagnetic element (102, 202) and the second ferromagnetic element (122, 222);
a third magnet (130, 230, 430, 440);
a shell (111,112) positioned at a predetermined distance from the first magnet (101, 201, 401) and the second magnet (121, 221), to at least partially envelop the first magnet (101, 201, 401) and the second magnet (121, 221);
a fourth magnet (103, 203) positioned around the first magnet (101, 201, 401); and
a fifth magnet (123, 223) positioned around the second magnet (121,221), wherein:
the predetermined distance is based on a desired magnetic field strength in the gap (150, 250, 450),
a thickness of the shell (111,112) corresponds to the predetermined distance,
the first magnet (101, 201, 401) and the second magnet (122, 222) have the same magnetization direction along a first axis,
the fourth magnet (103, 203) and the fifth magnet (123, 223) each have a magnetization direction perpendicular to the magnetization direction of the first magnet (101, 201, 401) along a second axis perpendicular to the first axis, wherein the fourth magnet (103, 203) has a magnetization direction away from the first magnet (101, 201, 401) and the fifth magnet (123, 223) has a magnetization direction towards the second magnet (122, 222), and
the third magnet (130, 230, 430, 440) has a magnetization direction which is opposite to the magnetization direction of the first and second magnets (201,221) along the first axis,
**characterised in that**
the third magnet (130, 230, 430, 440) is positioned between the first ferromagnetic element (102, 202) and the second ferromagnetic element (122, 222), and the third magnet (130, 230, 430, 440) being within the gap (150, 250, 450).

2. The magnetic field device (100, 200) of claim 1, wherein the shell (111,112) at least partially envelops the first ferromagnetic element (102, 202) and second ferromagnetic element (122, 222).

3. The magnetic field device (100, 200) of claim 1, further including one or more additional third magnets (130, 230, 430, 440).

4. The magnetic field device (100, 200) of claim 1, wherein the thickness of the shell (111,112) is inversely proportional to the distance.

5. The magnetic field device (100, 200) of claim 4, wherein the thickness of the shell (111,112) is based on the distance exceeding a predetermined threshold.

6. The magnetic field device (100, 200) of claim 1, wherein the distance is also based on the weight of the at least one magnet.

7. The magnetic field device (100, 200) of claim 1, wherein at least one of the first magnet (101, 201, 401), the second magnet (121, 221) and the third magnet (130, 230, 430) is a permanent magnet, a superconducting magnet, a resistive magnet, or any combination thereof.

8. The magnetic field device (100, 200) of claim 1, wherein the first magnet (101, 201, 401), the second magnet (121, 221), the third magnet (130, 230, 430), and the shell (111,112) have dimensions that are based on the desired magnetic field strength, a type of object to be imaged, or any combination thereof.

9. The magnetic field device (100, 200) of claim 1, wherein the shell (111,112) comprises a metal alloy.

10. The magnetic field device (100, 200) of claim 1, wherein the distance is 50 millimeters.

11. A method of directing magnetic fields into a measurement volume, the method comprising:
providing a magnetic field device (100, 200) according to any preceding claim;
generating, using the first magnet (101, 201, 401), a first magnetic field in a first direction with a first magnetic field strength;
distributing, using the first ferromagnetic element (102, 202), the first magnetic field into the measurement volume to create a substantially uniform magnetic flux;
generating, using the second magnet (121, 221), a second magnetic field in the first direction with a second magnetic field strength;
distributing, using the second ferromagnetic element (122, 222), the second magnetic field into the measurement volume to create a substantially uniform magnetic flux;
increasing the strength of the magnetic field in the measurement volume by generating, using the third magnet (130, 230, 430, 440), a third magnetic field with a third magnetic field strength and directing the third magnetic field in a second direction parallel and substantially opposite to the first direction.

12. The method of claim 11, further comprising:
positioning an object within the measurement volume; and
performing magnetic field analysis on the object.

## Patentansprüche

1. Magnetfeldgerät (100, 200) zur Durchführung einer Magnetfeldanalyse eines Objekts, das innerhalb eines Spalt des Geräts (100, 200) positioniert ist, durch Verwendung von Magnetresonanztomographie oder Kernspinresonanz, wobei das Gerät (100, 200) umfasst:
einen ersten Magneten (101, 201, 401);
ein erstes ferromagnetisches Element (102, 202), das neben dem ersten Magneten (101, 201, 401) positioniert ist;
einen zweiten Magneten (121, 221);
ein zweites ferromagnetisches Element (122, 222), das neben dem zweiten Magneten (121, 221) und relativ zu dem ersten ferromagnetischen Element (102, 202) positioniert ist, um den Spalt (150, 250, 450) zwischen dem ersten ferromagnetischen Element (102, 202) und dem zweiten ferromagnetischen Element (122, 222) zu erzeugen;
einen dritten Magneten (130, 230, 430, 440);
eine Hülle (111, 112), die in einem vorbestimmten Abstand zu dem ersten Magneten (101, 201, 401) und dem zweiten Magneten (121, 221) positioniert ist, um den ersten Magneten (101, 201, 401) und den zweiten Magneten (121, 221) mindestens teilweise zu umhüllen;
einen vierten Magneten (103, 203), der um den ersten Magneten (101, 201, 401) herum positioniert ist; und
einen fünften Magneten (123, 223), der um den zweiten Magneten (121, 221) herum positioniert ist;
wobei:
der vorbestimmte Abstand auf einer gewünschten Magnetfeldstärke in dem Spalt (150, 250, 450) basiert,
eine Dicke der Hülle (111, 112) dem vorbestimmten Abstand entspricht,
der erste Magnet (101, 201, 401) und der zweite Magnet (122, 222) dieselbe Magnetisierungsrichtung entlang einer ersten Achse aufweisen,
der vierte Magnet (103, 203) und der fünfte Magnet (123, 223) jeweils eine Magnetisierungsrichtung senkrecht zu der Magnetisierungsrichtung des ersten Magneten (101, 201, 401) entlang einer zweiten Achse senkrecht zur ersten Achse aufweisen, wobei der vierte Magnet (103, 203) eine Magnetisierungsrichtung weg von dem ersten Magneten (101, 201, 401) aufweist und der fünfte Magnet (123, 223) eine Magnetisierungsrichtung hin zu dem zweiten Magneten (122, 222) aufweist, und
der dritte Magnet (130, 230, 430, 440) eine Magnetisierungsrichtung aufweist, die entgegengesetzt zu der Magnetisierungsrichtung des ersten und zweiten Magneten (201, 221) entlang der ersten Achse ist,
**dadurch gekennzeichnet, dass** der dritte Magnet (130, 230, 430, 440) zwischen dem ersten ferromagnetischen Element (102, 202) und dem zweiten ferromagnetischen Element (122, 222) positioniert ist und sich der dritte Magnet (130, 230, 430, 440) innerhalb des Spalts (150, 250, 450) befindet.

2. Magnetfeldgerät (100, 200) nach Anspruch 1, wobei die Hülle (111, 112) mindestens teilweise das erste ferromagnetische Element (102, 202) und das zweite ferromagnetische Element (122, 222) umhüllt.

3. Magnetfeldgerät (100, 200) nach Anspruch 1, ferner beinhaltend einen oder mehrere zusätzliche dritte Magnete (130, 230, 430, 440).

4. Magnetfeldgerät (100, 200) nach Anspruch 1, wobei die Dicke der Hülle (111, 112) umgekehrt proportional zu dem Abstand ist.

5. Magnetfeldgerät (100, 200) nach Anspruch 4, wobei die Dicke der Hülle (111, 112) darauf basiert ist, dass der Abstand eine vorbestimmte Schwelle überschreitet.

6. Magnetfeldgerät (100, 200) nach Anspruch 1, wobei der Abstand auch auf dem Gewicht des mindestens einen Magneten basiert.

7. Magnetfeldgerät (100, 200) nach Anspruch 1, wobei mindestens einer des ersten Magneten (101, 201, 401), des zweiten Magneten (121, 221) und des dritten Magneten (130, 230, 430) ein Permanentmagnet, ein supraleitender Magnet, ein Widerstandsmagnet oder eine beliebige Kombination davon ist.

8. Magnetfeldgerät (100, 200) nach Anspruch 1, wobei der erste Magnet (101, 201, 401), der zweite Magnet (121, 221), der dritte Magnet (130, 230, 430) und die Hülle (111, 112) Abmessungen aufweisen, die auf der gewünschten Magnetfeldstärke, einer Art des abzubildenden Objekts oder einer beliebigen Kombination davon basieren.

9. Magnetfeldgerät (100, 200) nach Anspruch 1, wobei die Hülle (111, 112) eine Metalllegierung umfasst.

10. Magnetfeldgerät (100, 200) nach Anspruch 1, wobei der Abstand 50 Millimeter beträgt.

11. Verfahren zum Richten von Magnetfeldern in ein Messvolumen, wobei das Verfahren umfasst:
Bereitstellen eines Magnetfeldgeräts (100, 200) nach einem vorhergehenden Anspruch;
Erzeugen, unter Verwendung des ersten Magneten (101, 201, 401), eines ersten Magnetfelds in einer ersten Richtung mit einer ersten Magnetfeldstärke;
Verteilen, unter Verwendung des ersten ferromagnetischen Elements (102, 202), des ersten Magnetfelds in das Messvolumen, um einen im Wesentlichen gleichmäßigen Magnetfluss zu erzeugen;
Erzeugen, unter Verwendung des zweiten Magneten (121, 221), eines zweiten Magnetfelds in der ersten Richtung mit einer zweiten Magnetfeldstärke;
Verteilen, unter Verwendung des zweiten ferromagnetischen Elements (122, 222), des zweiten Magnetfelds in das Messvolumen, um einen im Wesentlichen gleichmäßigen Magnetfluss zu erzeugen;
Erhöhen der Stärke des Magnetfelds in dem Messvolumen durch Erzeugen, unter Verwendung des dritten Magneten (130, 230, 430, 440), eines dritten Magnetfelds mit einer dritten Magnetfeldstärke und Richten des dritten Magnetfelds in einer zweiten Richtung parallel und im Wesentlichen entgegengesetzt zu der ersten Richtung.

12. Verfahren nach Anspruch 11, ferner umfassend:
Positionieren eines Objekts innerhalb des Messvolumens; und
Durchführen einer Magnetfeldanalyse an dem Objekt.

## Revendications

1. Dispositif à champ magnétique (100, 200) permettant de réaliser une analyse de champ magnétique d'un objet positionné dans un espace du dispositif (100, 200), au moyen d'une imagerie par résonance magnétique ou d'une résonance magnétique nucléaire, le dispositif (100, 200) comprenant :
un premier aimant (101, 201, 401) ;
un premier élément ferromagnétique (102, 202) positionné adjacent au premier aimant (101, 201, 401) ;
un deuxième aimant (121, 221) ;
un second élément ferromagnétique (122, 222) positionné adjacent au deuxième aimant (121, 221) et par rapport au premier élément ferromagnétique (102, 202) pour créer l'espace (150, 250, 450) entre le premier élément ferromagnétique (102, 202) et le second élément ferromagnétique (122, 222) ;
un troisième aimant (130, 230, 430, 440) ;
une coque (111, 112) positionnée à une distance prédéterminée du premier aimant (101, 201, 401) et du deuxième aimant (121, 221), afin d'envelopper au moins en partie le premier aimant (101, 201, 401) et le deuxième aimant (121, 221) ;
un quatrième aimant (103, 203) positionné autour du premier aimant (101, 201, 401) ; et
un cinquième aimant (123, 223) positionné autour du deuxième aimant (121, 221),
la distance prédéterminée étant basée sur une intensité de champ magnétique
souhaitée dans l'espace (150, 250, 450),
une épaisseur de la coque (111, 112) correspondant à la distance prédéterminée, le premier aimant (101, 201, 401) et le deuxième aimant (122, 222) ayant la même direction d'aimantation le long d'un premier axe,
le quatrième aimant (103, 203) et le cinquième aimant (123, 223) ayant chacun une direction d'aimantation perpendiculaire à la direction d'aimantation du premier aimant (101, 201, 401) le long d'un second axe perpendiculaire au premier axe, le quatrième aimant (103, 203) ayant une direction d'aimantation s'éloignant du premier aimant (101, 201, 401) et le cinquième aimant (123, 223) ayant une direction d'aimantation vers le deuxième aimant (122, 222), et
le troisième aimant (130, 230, 430, 440) ayant une direction d'aimantation qui est opposée à la direction d'aimantation des premier et deuxième aimants (201, 221) le long du premier axe,
le dispositif étant **caractérisé en ce que** le troisième aimant (130, 230, 430, 440) est positionné entre le premier élément ferromagnétique (102, 202) et le second élément ferromagnétique (122, 222), et **en ce que** le troisième aimant (130, 230, 430, 440) se trouvant dans l'espace (150, 250, 450).

2. Dispositif à champ magnétique (100, 200) selon la revendication 1, la coque (111, 112) enveloppant au moins en partie le premier élément ferromagnétique (102, 202) et le second élément ferromagnétique (122, 222).

3. Dispositif à champ magnétique (100, 200) selon la revendication 1, comprenant en outre un ou plusieurs troisièmes aimants supplémentaires (130, 230, 430, 440).

4. Dispositif à champ magnétique (100, 200) selon la revendication 1, l'épaisseur de la coque (111, 112) étant inversement proportionnelle à la distance.

5. Dispositif à champ magnétique (100, 200) selon la revendication 4, l'épaisseur de la coque (111, 112) étant basée sur le fait que la distance dépasse un seuil prédéterminé.

6. Dispositif à champ magnétique (100, 200) selon la revendication 1, la distance étant également basée sur le poids de l'au moins un aimant.

7. Dispositif à champ magnétique (100, 200) selon la revendication 1, au moins un aimant parmi le premier aimant (101, 201, 401), le deuxième aimant (121, 221) et le troisième aimant (130, 230, 430) est un aimant permanent, un aimant supraconducteur, un aimant résistif ou toute combinaison de ceux-ci.

8. Dispositif à champ magnétique (100, 200) selon la revendication 1, le premier aimant (101, 201, 401), le deuxième aimant (121, 221), le troisième aimant (130, 230, 430) et la coque (111, 112) ayant des dimensions qui sont basées sur l'intensité de champ magnétique souhaitée, un type d'objet à imager ou toute combinaison de ceux-ci.

9. Dispositif à champ magnétique (100, 200) selon la revendication 1, la coque (111, 112) comprenant un alliage métallique.

10. Dispositif à champ magnétique (100, 200) selon la revendication 1, la distance étant de 50 millimètres.

11. Procédé permettant de diriger des champs magnétiques dans un volume de mesure, le procédé consistant à :
fournir un dispositif à champ magnétique (100, 200) selon l'une quelconque des revendications précédentes ;
générer, au moyen du premier aimant (101, 201, 401), un premier champ magnétique dans une première direction avec une première intensité de champ magnétique ;
répartir, au moyen du premier élément ferromagnétique (102, 202), le premier champ magnétique dans le volume de mesure afin de créer un flux magnétique sensiblement uniforme ;
générer, au moyen du deuxième aimant (121, 221), un deuxième champ magnétique dans la première direction avec une deuxième intensité de champ magnétique ;
répartir, au moyen du second élément ferromagnétique (122, 222), le deuxième champ magnétique dans le volume de mesure afin de créer un flux magnétique sensiblement uniforme ;
augmenter l'intensité du champ magnétique dans le volume de mesure en générant, au moyen du troisième aimant (130, 230, 430, 440), un troisième champ magnétique avec une troisième intensité de champ magnétique et en dirigeant le troisième champ magnétique dans une seconde direction parallèle et sensiblement opposée à la première direction.

12. Procédé selon la revendication 11, consistant en outre à :
positionner un objet dans le volume de mesure ; et
réaliser une analyse de champ magnétique sur l'objet.
